# EUROPÄISCHE PATENTSCHRIFT

(11) **EP 2 756 598 B1**
(45) Veröffentlichungstag und Bekanntmachung des Hinweises auf die Patenterteilung: **30.10.2019**
(21) Anmeldenummer: 11790734.5
(22) Anmeldetag: 07.11.2011
(51) Int. Cl.: H03K 17/0812

(54) **SCHUTZEINRICHTUNG FÜR EINEN SPANNUNGSGESTEUERTEN HALBLEITERSCHALTER**
PROTECTIVE DEVICE FOR A VOLTAGE-CONTROLLED SEMICONDUCTOR SWITCH
DISPOSITIF DE PROTECTION POUR UN COMMUTATEUR À SEMI-CONDUCTEUR COMMANDÉ EN TENSION

(43) Veröffentlichungstag der Anmeldung: 23.07.2014
(73) Patentinhaber: Siemens Aktiengesellschaft, 80333 München (DE)
(72) Erfinder: ECKEL, Hans-Günter, 18059 Rostock (DE); PIERSTORF, Steffen, 90443 Nürnberg (DE)
(86) Internationale Anmeldenummer: PCT/EP2011/069523
(87) Internationale Veröffentlichungsnummer: WO 2013/068028

(56) Entgegenhaltungen:
- EP-A1- 0 814 564
- EP-A1- 1 191 692
- WO-A1-2009/103584
- DE-A1-102007 012 034

## Beschreibung

Die Erfindung bezieht sich auf eine Schutzeinrichtung für einen spannungsgesteuerten Halbleiterschalter mit einem Gate-Anschluss, einem Leistungsemitter-Anschluss, einem Hilfsemitter-Anschluss und einem Kollektor-Anschluss, wobei der Halbleiterschalter einen Strom zwischen dem Kollektor-Anschluss und dem Leistungsemitter-Anschluss schalten kann. Eine solche Schutzeinrichtung kann beispielsweise für spannungsgesteuerte IGBT-Halbleiterschalter (IGBT: Bipolartransistor mit integrierter Gateelektrode) oder MOSFET- Halbleiterschalter (MOSFET: Metall-Oxid-Feldeffekttransistor) eingesetzt werden.

Aus der Offenlegungsschrift EP 0 814 564 A1 ist ein elektronischer Schalter in Form eines IGBT bekannt, zwischen dessen Gate-Anschluss und Leistungsemitter-Anschluss eine Sensorschaltung angeordnet ist. Die Sensorschaltung weist zwei antiseriell geschaltete Zenerdioden und einen dazu in Reihe geschalteten Widerstand auf. Die Sensorschaltung erfasst die Änderungsgeschwindigkeit des durch den Leistungsemitter fließenden Stroms und verlangsamt bei Überschreiten eines Grenzwerts den Ein- bzw. Ausschaltvorgang des IGBTs.

In der Offenlegungsschrift DE102007012034 A1 ist bei einem spannungsgesteuerten Halbleiterschalter eine Spannungsbegrenzungsschaltung zwischen dem Steueranschluss und dem Leistungsemitter als Überspannungsschutz vorgesehen.

In Spannungszwischenkreis-Umrichtern können durch Kurzschlüsse oder Erdschlüsse in der Last sehr hohe Ströme fließen, die die in den Umrichtern eingesetzten spannungsgesteuerten Halbleiterschalter unter Umständen zerstören können. Während das Einschalten eines spannungsgesteuerten Halbleiterschalters auf einen bereits bestehenden Kurzschluss von heutigen Halbleiterschaltern üblicherweise für Zeitspannen von mindestens 10 µs zerstörungsfrei überstanden wird - die Zeitspanne reicht üblicherweise aus, um einen Kurzschluss zu erkennen und abzuschalten - ist ein Kurzschluss bei bereits eingeschaltetem und stromführendem Halbleiterschalter deutlich kritischer. Ein solcher Kurzschluss wird als "Typ 2"-Kurzschluss bezeichnet (vgl. Konferenzbeitrag "Influence of the Gate Drive on the Short-Circuit Type 2 and Type 3 Behaviour of HV-IGBT" (PCIM2010, 4. bis 6. Mai 2010, Nürnberg, Deutschland, VDE-Verlag Berlin, ISBN: 978-3-8007-3229-6). Charakteristisch für einen Kurzschluss des Typs 2 ist, dass eine Kurzschlussstromspitze, die deutlich höher als der stationäre Kurzschlussstrom ist, sowie eine Spannungsspitze beim Übergang von der dynamischen Kurzschlussstromspitze auf den stationären Kurzschlussstrom auftreten.

Der Erfindung liegt die Aufgabe zugrunde, eine Schutzeinrichtung für einen spannungsgesteuerten Halbleiterschalter anzugeben, die auch im Falle eines Kurzschlusses des Typs 2 zuverlässig schützt.

Diese Aufgabe wird erfindungsgemäß durch eine Schutzeinrichtung mit den Merkmalen gemäß Patentanspruch 1 gelöst. Vorteilhafte Ausgestaltungen der erfindungsgemäßen Schutzeinrichtung sind in Unteransprüchen angegeben.

Danach ist erfindungsgemäß eine Schutzeinrichtung vorgesehen mit: einer Spannungsbegrenzungseinrichtung, die die Spannung zwischen dem Gate-Anschluss und dem Leistungsemitter-Anschluss begrenzt, und einer mit der Spannungsbegrenzungseinrichtung verbundenen Deaktivierungseinrichtung, die die Spannungsbegrenzungseinrichtung während des Einschaltens des Halbleiterschalters deaktiviert.

Ein wesentlicher Vorteil der erfindungsgemäßen Schutzeinrichtung ist darin zu sehen, dass durch die erfindungsgemäß vorgesehene Begrenzung der Spannung zwischen dem Gate-Anschluss und dem Leistungsemitter-Anschluss im Kurzschlussfall eine Absenkung auch der Spannung zwischen dem Gate-Anschluss und dem Hilfsemitter-Anschluss herbeigeführt wird, wodurch die auftretende Kurzschlussstromamplitude in vorteilhafter Weise abgesenkt wird.

Ein weiterer wesentlicher Vorteil der erfindungsgemäßen Schutzeinrichtung besteht in der erfindungsgemäß vorgesehenen Deaktivierung der Spannungsbegrenzungseinrichtung während der Einschaltphase des Halbleiterschalters, um Schaltverluste während des Einschaltens zu vermeiden bzw. zu minimieren, die andernfalls durch eine Absenkung der Gate-Leistungsemitter-Spannung auftreten würden.

Zusammengefasst wird also durch die erfindungsgemäß vorgesehene Spannungsbegrenzungseinrichtung ein optimales Verhalten während eines Kurzschlusses des Typs 2 erreicht, wobei dennoch sichergestellt wird, dass die Verluste während des Einschaltens des Halbleiterschalters im Normalbetrieb nicht signifikant erhöht werden.

Gemäß einer besonders bevorzugten Ausgestaltung der Schutzeinrichtung ist vorgesehen, dass die Schutzeinrichtung eine kapazitive Koppeleinrichtung aufweist, die eine kapazitive Kopplung zwischen dem Gate-Anschluss und dem Leistungsemitter-Anschluss bewirkt. Durch eine kapazitive Kopplung zwischen dem Gate-Anschluss und dem Leistungsemitter-Anschluss wird in vorteilhafter Weise ein Anheben der Gate-Leistungsemitter-Spannung nach Erreichen der Kurzschlussamplitude erreicht, was zu einem besonders sanften Übergang von der Kurzschlussstromamplitude zum stationären Kurzschlussstrom und damit zu einer besonders niedrigen Überspannungsspitze führt.

Als vorteilhaft wird es angesehen, wenn die Deaktivierungseinrichtung eingangsseitig mit der Spannung zwischen dem Gate-Anschluss und dem Hilfsemitter-Anschluss beaufschlagt ist und sie die Spannungsbegrenzungseinrichtung in Abhängigkeit von der Gate-Hilfsemitter-Spannung deaktiviert.

Vorzugsweise ist die Deaktivierungseinrichtung ausgangsseitig mit der Spannungsbegrenzungseinrichtung in Reihe geschaltet.

Um eine zuverlässige Deaktivierung der Spannungsbegrenzungseinrichtung während des Einschaltens des Halbleiterschalters zu erreichen, wird es als vorteilhaft angesehen, wenn die Deaktivierungseinrichtung derart ausgestaltet ist, dass sie im Falle eines Spannungssprungs der zwischen dem Gate-Anschluss und dem Hilfsemitter-Anschluss anliegenden Gate-Hilfsemitter-Spannung die Spannungsbegrenzungseinrichtung deaktiviert.

Um zu erreichen, dass die Deaktivierung der Spannungsbegrenzungseinrichtung nach Abschluss des Einschaltvorgangs automatisch beendet wird, wird es als vorteilhaft angesehen, wenn die Deaktivierungseinrichtung zumindest ein Zeitglied aufweist, dessen Zeitkonstante die Zeitdauer der Deaktivierung der Spannungsbegrenzungseinrichtung nach einem Spannungssprung der Gate-Hilfsemitter-Spannung zumindest auch bestimmt.

Vorzugsweise ist das Zeitglied ein RC-Zeitglied, das durch zumindest einen Kondensator und zumindest einen Widerstand gebildet ist.

Die Deaktivierungseinrichtung weist bevorzugt ein spannungssteuertes Schaltelement auf, dessen Steuer-Anschluss mit einer mit der Gate-Hilfsemitter-Spannung erzeugten Steuerspannung beaufschlagt ist.

Der Steuer-Anschluss des spannungsgesteuerten Schaltelements ist vorzugsweise über ein Zeitglied - beispielsweise das bereits oben erwähnte Zeitglied - mit der Gate-Hilfsemitter-Spannung beaufschlagt. Das Zeitglied kann beispielsweise ein RC-Glied sein, das durch zumindest einen Kondensator und zumindest einen Widerstand gebildet ist.

Die Erfindung bezieht sich darüber hinaus auf eine Anordnung mit einem spannungsgesteuerten Halbleiterschalter, einer Schutzeinrichtung, wie sie oben beschrieben worden ist, und einer Ansteuerschaltung zum Ansteuern des Halbleiterschalters, wobei die Ansteuerschaltung an den Gate-Anschluss und den Hilfsemitter-Anschluss angeschlossen ist und den spannungsgesteuerten Halbleiterschalter über die Gate-Hilfsemitter-Spannung steuert.

Bezüglich der Vorteile der erfindungsgemäßen Anordnung sei auf die obigen Ausführungen im Zusammenhang mit den Vorteilen der erfindungsgemäßen Schutzeinrichtung verwiesen, da die Vorteile der erfindungsgemäßen Anordnung denen der erfindungsgemäßen Schutzeinrichtung im Wesentlichen entsprechen.

Die Erfindung bezieht sich darüber hinaus auf ein Verfahren zum Schützen eines spannungsgesteuerten Halbleiterschalters, der mit einem Gate-Anschluss, einem Leistungsemitter-Anschluss, einem Hilfsemitter-Anschluss und einem Kollektor-Anschluss ausgestattet ist. Erfindungsgemäß ist vorgesehen, dass die Spannung zwischen dem Gate-Anschluss und dem Leistungsemitter-Anschluss mit einer Spannungsbegrenzungseinrichtung begrenzt wird, wenn der spannungsgesteuerte Halbleiterschalter eingeschaltet ist, und die Spannungsbegrenzungseinrichtung mit einer Deaktivierungseinrichtung während des Einschaltens des Halbleiterschalters deaktiviert wird.

Bezüglich der Vorteile des erfindungsgemäßen Verfahrens sei auf die obigen Ausführungen im Zusammenhang mit den Vorteilen der erfindungsgemäßen Schutzeinrichtung verwiesen, da die Vorteile des erfindungsgemäßen Verfahrens denen der erfindungsgemäßen Schutzeinrichtung im Wesentlichen entsprechen.

Gemäß einer besonders bevorzugten Ausgestaltung des Verfahrens ist vorgesehen, dass die Spannung zwischen dem Gate-Anschluss und dem Hilfsemitter-Anschluss auf einen Spannungssprung hin überwacht wird und die Spannungsbegrenzungseinrichtung bei Auftreten eines solchen Spannungssprungs deaktiviert wird.

Die Erfindung wird nachfolgend anhand eines Ausführungsbeispiels näher erläutert; dabei zeigt eine Figur ein Ausführungsbeispiel für eine erfindungsgemäße Anordnung, die mit einer erfindungsgemäßen Schutzeinrichtung ausgestattet ist. Anhand der in der Figur dargestellten Anordnung wird auch das erfindungsgemäße Verfahren beispielhaft erläutert.

In der Figur sieht man eine Anordnung mit einem spannungsgesteuerten Halbleiterschalter 10, der einen Kollektor-Anschluss K10, einen Leistungsemitter-Anschluss L10, einen Hilfsemitter-Anschluss H10 sowie einen Gate-Anschluss G10 aufweist. Bei dem spannungsgesteuerten Halbleiterschalter 10 kann es sich beispielsweise um einen IGBT, also einen bipolaren Transistor mit integrierter Gateelektrode, oder um einen MOSFET-(MOSFET: Metall-Oxid-Feldeffekttransistor) handeln.

Der Hilfsemitter-Anschluss H10 und der Leistungsemitter-Anschluss L10 des Halbleiterschalters 10 unterscheiden sich hinsichtlich ihrer Leitungslängen zum tatsächlichen physikalischen Emitter-Anschlusspunkt E. Während der Hilfsemitter-Anschluss H10 mit einer sehr kurzen elektrischen Leitung an den physikalischen Emitter-Anschlusspunkt E angeschlossen ist, ist die elektrische Leitung zwischen dem Leistungsemitter-Anschluss L10 und dem physikalischen Emitter-Anschlusspunkt E deutlich länger. Elektrisch sind somit der Hilfsemitter-Anschluss H10 und der Leistungsemitter-Anschluss L10 durch eine Induktivität L miteinander gekoppelt, die durch die Leitungslänge der Leitung bis zum Leistungsemitter-Anschluss L10 bestimmt wird. Die Leitungslänge zwischen dem physikalischen Emitter-Anschlusspunkt E und dem Leistungsemitter-Anschluss L10 liegt üblicherweise in der Länge zwischen 1 und 5 cm.

Für den Betrieb des Halbleiterschalters 10 wird der Hilfsemitter-Anschluss H10 zum Einspeisen einer Steuerspannung und der Leistungsemitter-Anschluss L10 zum Anschließen der elektrischen Last verwendet. Der Laststrom fließt somit über den Kollektor-Anschluss K10 und den Leistungsemitter-Anschluss L10, und der Steuerstrom fließt über den Gate-Anschluss G10 und den Hilfsemitter-Anschluss H10.

Der Halbleiterschalter 10 wird von einer Ansteuerschaltung 20 angesteuert, deren Ausgang A20a an den Gate-Anschluss G10 des Halbleiterschalters 10 und deren Ausgang A20b an den Hilfsemitter-Anschluss H10 angeschlossen ist.

Bei dem in der Figur gezeigten Ausführungsbeispiel schaltet die Ansteuerschaltung 20 den Halbleiterschalter 10 beispielsweise ein, indem sie eine positive Spannung zwischen dem Gate-Anschluss G10 und dem Hilfsemitter-Anschluss H10 erzeugt. Sie schaltet den Halbleiterschalter 10 ab, indem sie die Spannung zwischen dem Gate-Anschluss G10 und dem Hilfsemitter-Anschluss H10 abschaltet.

In der Figur lässt sich erkennen, dass zwischen die Ansteuerschaltung 20 und den Halbleiterschalter 10 eine Schutzeinrichtung 30 geschaltet ist. Die Schutzeinrichtung 30 umfasst eine Spannungsbegrenzungseinrichtung 40 (in Form einer Spannungsbegrenzungsschaltung), eine Deaktivierungseinrichtung 50 (in Form einer Deaktivierungsschaltung) sowie eine kapazitive Koppeleinrichtung 60 (in Form einer Koppelschaltung).

Die kapazitive Koppeleinrichtung 60 wird durch einen Kondensator C1 gebildet, der zwischen den Gate-Anschluss G10 und den Leistungsemitter-Anschluss L10 des Halbleiterschalters 10 geschaltet ist.

Die Deaktivierungseinrichtung 50 weist zwei Eingänge E50a und E50b auf, von denen der Eingang E50a mit dem Gate-Anschluss G10 des Halbleiterschalters und der Eingang E50b mit dem Hilfsemitter-Anschluss H10 des Halbleiterschalters 10 verbunden ist. Die beiden Eingänge E50a und E50b stehen somit ebenfalls mit den beiden Ausgängen A20a und A20b der Ansteuerschaltung 20 in Verbindung.

Ausgangsseitig ist die Deaktivierungseinrichtung 50 mit ihrem Ausgang A50a mit dem Gate-Anschluss G10 des Halbleiterschalters 10 verbunden. Ein anderer Ausgang A50b steht mit einem Anschluss A40a der Spannungsbegrenzungseinrichtung 40 in Verbindung. Ein weiterer Anschluss A40b der Spannungsbegrenzungseinrichtung 40 ist an den Leistungsemitter-Anschluss L10 des Halbleiterschalters 10 angeschlossen.

Durch die ausgangsseitige Verschaltung der Deaktivierungseinrichtung 50 und der Spannungsbegrenzungseinrichtung 40 wird eine Reihenschaltung gebildet, die den Gate-Anschluss G10 mit dem Leistungsemitter-Anschluss L10 verbindet.

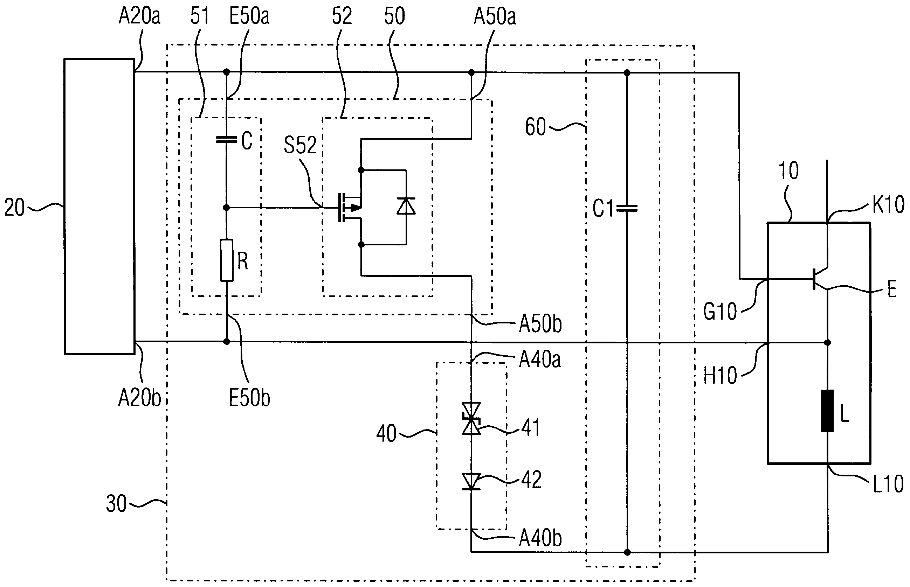

Die Spannungsbegrenzungseinrichtung 40 weist bei dem Ausführungsbeispiel gemäß Figur 1 eine Transildiode 41 sowie eine Diode 42 auf. Die Funktion der beiden Dioden 41 und 42 besteht darin, die Spannung zwischen dem Gate-Anschluss G10 und dem Leistungsemitter-Anschluss L10 im Kurzschlussfall abzusenken, wodurch auch die Spannung zwischen dem Gate-Anschluss G10 und dem Hilfsemitter-Anschluss H10 abgesenkt wird, wodurch es wiederum zu einer Absenkung der Kurzschlussamplitude kommt.

Die Deaktivierungseinrichtung 50 weist ein Zeitglied 51 sowie ein spannungsgesteuertes Schaltelement 52 auf, das eingangsseitig mit dem Zeitglied 51 verbunden ist. Ausgangsseitig bildet das spannungsgesteuerte Schaltelement 52 die Ausgänge A50a und A50b der Deaktivierungseinrichtung 50. Der Steuer-Anschluss S52 des Schaltelements 52 ist über das Zeitglied 51 mit einer Steuerspannung beaufschlagt, die mit der Spannung zwischen dem Gate-Anschluss G10 und dem Hilfsemitter-Anschluss H10 gebildet wird.

Bei dem Ausführungsbeispiel gemäß der Figur handelt es sich bei dem Zeitglied 51 um ein RC-Zeitglied, das durch einen Widerstand R sowie einen Kondensator C gebildet ist. Die Funktion des Zeitgliedes 51 besteht darin, das Schaltelement 52 beim Einschalten des Halbleiterschalters 10 auszuschalten bzw. ausgeschaltet zu lassen, so dass die Deaktivierungseinrichtung 50 die Spannungsbegrenzungseinrichtung 40 deaktiviert.

Wie bereits erwähnt, erfolgt das Einschalten des Halbleiterschalters 10 bei dem in der Figur gezeigten Ausführungsbeispiel durch das Anlegen einer positiven Gate-Hilfsemitter-Spannung an den Gate-Anschluss G10 und den Hilfsemitter-Anschluss H10 des Halbleiterschalters 10. Wird das Potential an dem Gate-Anschluss G10 beim Einschalten angehoben, so bleibt das Schaltelement 52 durch die am Steuer-Anschluss S52 anliegende Steuerspannung jedoch noch solange abgeschaltet, bis der Kondensator C des Zeitgliedes 51 aufgeladen ist. In der Zeitspanne, in der das Schaltelement 52 abgeschaltet bleibt, wird bzw. bleibt die Spannungsbegrenzungseinrichtung 40 deaktiviert, so dass diese auf die Einschaltphase des Halbleiterschalters 10 ohne Einfluss bleibt. Durch die Deaktivierung der Spannungsbegrenzungseinrichtung 40 in der Einschaltphase wird verhindert, dass der Stromanstieg di/dt beim Einschalten reduziert wird; dadurch werden die Einschaltverluste beim Einschalten des Halbleiterschalters 10 deutlich herabgesetzt.

Sobald der Kondensator C über den Widerstand R aufgeladen ist, wird das Schaltelement 52 eingeschaltet und die Spannungsbegrenzungseinrichtung 40 aktiviert, so dass diese in der Lage ist, im Fall eines Kurzschlusses in der Last die Spannung zwischen dem Gate-Anschluss G10 und dem Leistungsemitter-Anschluss L10 und damit die Spannung zwischen dem Gate-Anschluss G10 und dem Hilfsemitter-Anschluss H10 zu reduzieren und eine Absenkung der Kurzschlussstromamplitude im Kurzschlussfall herbeizuführen.

Die kapazitive Koppeleinrichtung 60 hat die Aufgabe, die Gate-Emitter-Spannung nach Erreichen der Kurzschlussstromamplitude im Kurzschlussfall wieder anzuheben und damit zu einem sanfteren Übergang von der Kurzschlussstromamplitude zum stationären Kurzschlussstrom und damit zu einer niedrigeren Überspannungsspitze zu führen.

Bei dem in der Figur gezeigten Ausführungsbeispiel weist die Spannungsbegrenzungseinrichtung 40 eine Transildiode 41 sowie eine Diode 42 auf. Alternativ kann die Spannungsbegrenzungseinrichtung auch durch eine einzige Zenerdiode und/oder eine Diode in Kombination mit einem vorgeladenen Kondensator gebildet sein.

Bei dem spannungsgesteuerten Schaltelement 52 kann es sich beispielsweise um einen MOSFET-Transistor handeln, dessen Source-Anschluss auf dem Gatepotential liegt und dessen Gate über einen Vorwiderstand (z. B. den Widerstand R des Zeitgliedes 51) mit dem Hilfsemitter-Anschluss H10 des Halbleiterschalters 10 verbunden ist.

Obwohl die Erfindung im Detail durch das bevorzugte Ausführungsbeispiel näher illustriert und beschrieben wurde, so ist die Erfindung nicht durch das offenbarte Beispiel eingeschränkt und andere Variationen können vom Fachmann hieraus abgeleitet werden, ohne den Schutzumfang der Erfindung zu verlassen.

### Bezugszeichenliste

- 10: Halbleiterschalter
- 20: Ansteuerschaltung
- 30: Schutzeinrichtung
- 40: Spannungsbegrenzungseinrichtung
- 41: Transildiode
- 42: Diode
- 50: Deaktivierungseinrichtung
- 51: Zeitglied
- 52: Schaltelement
- 60: Koppeleinrichtung

- A20a: Ausgang
- A20b: Ausgang
- A40a: Anschluss
- A40b: Anschluss
- A50a: Ausgang
- A50b: Ausgang
- C: Kondensator
- di/dt: Stromanstieg
- E: Emitter-Anschlusspunkt
- E50a: Eingang
- E50b: Eingang
- G10: Gate-Anschluss
- H10: Hilfsemitter-Anschluss
- K10: Kollektor-Anschluss
- L: Induktivität
- L10: Leistungsemitter-Anschluss
- R: Widerstand
- S52: Steuer-Anschluss
- T: Transistor

## Patentansprüche

1. Schutzeinrichtung (30) für einen spannungsgesteuerten Halbleiterschalter (10) mit einem Gate-Anschluss (G10), einem Leistungsemitter-Anschluss (L10), einem Hilfsemitter-Anschluss (H10) und einem Kollektor-Anschluss (K10), wobei der Halbleiterschalter (10) einen Strom zwischen dem Kollektor-Anschluss (K10) und dem Leistungsemitter-Anschluss (L10) schalten kann, die Schutzeinrichtung beinhaltend
- eine Spannungsbegrenzungseinrichtung (40), die die Spannung zwischen dem Gate-Anschluss (G10) und dem Leistungsemitter-Anschluss (L10) begrenzt,
**gekennzeichnet durch**
- eine mit der Spannungsbegrenzungseinrichtung (40) verbundene Deaktivierungseinrichtung (50), die die Spannungsbegrenzungseinrichtung (40) während des Einschaltens des Halbleiterschalters (10) deaktiviert und dadurch Einschaltverluste beim Einschalten des Halbleiterschalters (10) herabsetzt.

2. Schutzeinrichtung nach Anspruch 1,
**dadurch gekennzeichnet, dass**
die Schutzeinrichtung (30) eine kapazitive Koppeleinrichtung (60) aufweist, die eine kapazitive Kopplung zwischen dem Gate-Anschluss (G10) und dem Leistungsemitter-Anschluss (L10) bewirkt.

3. Schutzeinrichtung nach einem der voranstehenden Ansprüche,
**dadurch gekennzeichnet, dass**
die Deaktivierungseinrichtung (50) eingangsseitig mit der Spannung zwischen dem Gate-Anschluss (G10) und dem Hilfsemitter-Anschluss (H10) beaufschlagt ist und die Spannungsbegrenzungseinrichtung (40) in Abhängigkeit von der Gate-Hilfsemitter-Spannung deaktiviert.

4. Schutzeinrichtung nach einem der voranstehenden Ansprüche,
**dadurch gekennzeichnet, dass**
die Deaktivierungseinrichtung (50) ausgangsseitig mit der Spannungsbegrenzungseinrichtung (40) in Reihe geschaltet ist.

5. Schutzeinrichtung nach einem der voranstehenden Ansprüche,
**dadurch gekennzeichnet, dass**
die Deaktivierungseinrichtung (50) derart ausgestaltet ist, dass sie im Falle eines Spannungssprungs der zwischen dem Gate-Anschluss (G10) und dem Hilfsemitter-Anschluss (H10) anliegenden Gate-Hilfsemitter-Spannung die Spannungsbegrenzungseinrichtung (40) deaktiviert.

6. Schutzeinrichtung nach einem der voranstehenden Ansprüche,
**dadurch gekennzeichnet, dass**
- die Deaktivierungseinrichtung (50) zumindest ein Zeitglied (51) aufweist,
- wobei die Zeitkonstante des Zeitgliedes (51) die Zeitdauer der Deaktivierung der Spannungsbegrenzungseinrichtung (40) nach einem Spannungssprung der Gate-Hilfsemitter-Spannung zumindest auch bestimmt.

7. Schutzeinrichtung nach Anspruch 6,
**dadurch gekennzeichnet, dass**
das Zeitglied ein RC-Zeitglied ist, das durch zumindest einen Kondensator (C) und zumindest einen Widerstand (R) gebildet ist.

8. Schutzeinrichtung nach einem der voranstehenden Ansprüche,
**dadurch gekennzeichnet, dass**
die Deaktivierungseinrichtung (50) ein spannungsgesteuertes Schaltelement (52) aufweist, dessen Steuer-Anschluss (S52) mit einer mit der Gate-Hilfsemitter-Spannung erzeugten Steuerspannung beaufschlagt ist.

9. Schutzeinrichtung nach Anspruch 8,
**dadurch gekennzeichnet, dass** der Steuer-Anschluss (S52) des spannungsgesteuerten Schaltelements (52) über ein Zeitglied (51) mit der Gate-Hilfsemitter-Spannung beaufschlagt ist.

10. Anordnung mit einem spannungsgesteuerten Halbleiterschalter (10), einer Schutzeinrichtung (30) nach einem der voranstehenden Ansprüche und einer Ansteuerschaltung (20) zum Ansteuern des Halbleiterschalters (10), wobei die Ansteuerschaltung an den Gate-Anschluss (G10) und den Hilfsemitter-Anschluss (H10) angeschlossen ist und den spannungsgesteuerten Halbleiterschalter (10) über die Gate-Hilfsemitter-Spannung steuert.

11. Verfahren zum Schützen eines spannungsgesteuerten Halbleiterschalters (10), der mit einem Gate-Anschluss (G10), einem Leistungsemitter-Anschluss (L10), einem Hilfsemitter-Anschluss (H10) und einem Kollektor-Anschluss (K10) ausgestattet ist, wobei
- die Spannung zwischen dem Gate-Anschluss (G10) und dem Leistungsemitter-Anschluss (L10) mit einer Spannungsbegrenzungseinrichtung (40) begrenzt wird, wenn der spannungsgesteuerte Halbleiterschalter (10) eingeschaltet ist,
**dadurch gekennzeichnet, dass**
- die Spannungsbegrenzungseinrichtung (40) mit einer Deaktivierungseinrichtung (50) während des Einschaltens des Halbleiterschalters (10) deaktiviert wird und dadurch Einschaltverluste beim Einschalten des Halbleiterschalters (10) herabgesetzt werden.

12. Verfahren nach Anspruch 11,
**dadurch gekennzeichnet, dass**
- die Spannung zwischen dem Gate-Anschluss und dem Hilfsemitter-Anschluss auf einen Spannungssprung hin überwacht wird und
- die Spannungsbegrenzungseinrichtung (40) bei Auftreten eines solchen Spannungssprungs deaktiviert wird.

## Claims

1. Protective device (30) for a voltage-controlled semiconductor switch (10) having a gate terminal (G10), a power emitter terminal (L10), an auxiliary emitter terminal (H10) and a collector terminal (K10), wherein the semiconductor switch (10) can switch a current between the collector terminal (K10) and the power emitter terminal (L10), the protective device containing
- a voltage limiting device (40), which limits the voltage between the gate terminal (G10) and the power emitter terminal (L10),
**characterized by**
- a deactivation device (50), which is connected to the voltage limiting device (40) and which deactivates the voltage limiting device (40) during the switch-on of the semiconductor switch (10) and thereby reduces switch-on losses during the switch-on of the semiconductor switch (10).

2. Protective device according to Claim 1,
**characterized in that**
the protective device (30) has a capacitive coupling device (60), which effects a capacitive coupling between the gate terminal (G10) and the power emitter terminal (L10).

3. Protective device according to either of the preceding claims,
**characterized in that**
the input side of the deactivation device (50) is supplied with the voltage between the gate terminal (G10) and the auxiliary emitter terminal (H10) and deactivates the voltage limiting device (40) depending on the gate-auxiliary emitter voltage.

4. Protective device according to one of the preceding claims,
**characterized in that**
the output side of the deactivation device (50) is connected in series with the voltage limiting device (40).

5. Protective device according to one of the preceding claims,
**characterized in that**
the deactivation device (50) is designed in such a way that it deactivates the voltage limiting device (40) in the event of a voltage jump of the gate-auxiliary emitter voltage applied between the gate terminal (G10) and the auxiliary emitter terminal (H10).

6. Protective device according to one of the preceding claims,
**characterized in that**
- the deactivation device (50) has at least one timer (51),
- wherein the time constant of the timer (51) at least also determines the period of the deactivation of the voltage limiting device (40) after a voltage jump of the gate-auxiliary emitter voltage.

7. Protective device according to Claim 6,
**characterized in that**
the timer is an RC timer, which is formed by at least one capacitor (C) and at least one resistor (R).

8. Protective device according to one of the preceding claims,
**characterized in that**
the deactivation device (50) has a voltage-controlled switching element (52), the control terminal (S52) of which is supplied with a control voltage generated by way of the gate-auxiliary emitter voltage.

9. Protective device according to Claim 8,
**characterized in that**
the control terminal (S52) of the voltage-controlled switching element (52) is supplied with the gate-auxiliary emitter voltage by means of a timer (51).

10. Arrangement having a voltage-controlled semiconductor switch (10), a protective device (30) according to one of the preceding claims and an actuation circuit (20) for actuating the semiconductor switch (10), wherein the actuation circuit is connected to the gate terminal (G10) and the auxiliary emitter terminal (H10) and controls the voltage-controlled semiconductor switch (10) by means of the gate-auxiliary emitter voltage.

11. Method for protecting a voltage-controlled semiconductor switch (10), which is provided with a gate terminal (G10), a power emitter terminal (L10), an auxiliary emitter terminal (H10) and a collector terminal (K10), wherein
- the voltage between the gate terminal (G10) and the power emitter terminal (L10) is limited by way of a voltage limiting device (40) when the voltage-controlled semiconductor switch (10) is switched on,
**characterized in that**
- the voltage limiting device (40) is deactivated by way of a deactivation device (50) during the switch-on of the semiconductor switch (10) and switch-on losses during the switch-on of the semiconductor switch (10) are thereby reduced.

12. Method according to Claim 11,
**characterized in that**
- the voltage between the gate terminal and the auxiliary emitter terminal is monitored for a voltage jump and
- the voltage limiting device (40) is deactivated in the case of such a voltage jump arising.

## Revendications

1. Dispositif (30) de protection d'un interrupteur (10) à semi-conducteur commandé en tension, comprenant une borne (G10) de grille, une borne (L10) d'émetteur de puissance, une borne (H10) d'émetteur auxiliaire et une borne (K10) de collecteur, l'interrupteur (10) à semi-conducteur pouvant faire passer un courant entre la borne (K10) de collecteur et la borne (L10) d'émetteur de puissance, le dispositif de protection comportant
- un dispositif (40) de limitation de la tension, qui limite la tension entre la borne (G10) de grille et la borne (L10) d'émetteur de puissance,
**caractérisé par**
- un dispositif (50) de désactivation, qui est relié au dispositif (40) de limitation de la tension, qui désactive le dispositif (40) de limitation de la tension pendant la fermeture de l'interrupteur (10) à semi-conducteur et diminue ainsi des pertes de fermeture à la fermeture de l'interrupteur (10) à semi-conducteur.

2. Dispositif de protection suivant la revendication 1,
**caractérisé en ce que**
le dispositif (30) de protection a un dispositif (60) de couplage capacitif, qui provoque un couplage capacitif entre la borne (G10) de grille et la borne (L10) d'émetteur de puissance.

3. Dispositif de protection suivant l'une des revendications précédentes,
**caractérisé en ce que**
le dispositif (50) de désactivation est soumis, du côté de l'entrée, à la tension entre la borne (G10) de grille et la borne (H10) d'émetteur auxiliaire et désactive le dispositif (40) de limitation de la tension en fonction de la tension grille-émetteur auxiliaire.

4. Dispositif de protection suivant l'une des revendications précédentes,
**caractérisé en ce que** le dispositif (50) de désactivation est monté en série du côté de la sortie avec le dispositif (40) de limitation de la tension.

5. Dispositif de protection suivant l'une des revendications précédentes,
**caractérisé en ce que**
le dispositif (50) de désactivation est conformé de manière à désactiver les dispositifs (4) de limitation de la tension dans le cas d'un saut de la tension grille-émetteur auxiliaire s'appliquant entre la borne (G10) de grille et la borne (H10) d'émetteur auxiliaire.

6. Dispositif de protection suivant l'une des revendications précédentes,
**caractérisé en ce que**
- le dispositif (5) de désactivation a au moins un relais (51) temporisateur,
- dans lequel la constante de temps du relais (51) temporisateur détermine au moins aussi la durée de la désactivation du dispositif (40) de limitation de la tension après un saut de la tension grille-émetteur auxiliaire.

7. Dispositif de protection suivant la revendication 6,
**caractérisé en ce que**
le relais temporisateur est un relais temporisateur RC formé d'au moins un condensateur (C) et d'au moins une résistance (R).

8. Dispositif de protection suivant l'une des revendications précédentes,
**caractérisé en ce que**
le dispositif (50) de désactivation a un élément (52) de coupure commandé en tension, dont la borne (S52) de commande est soumise à une tension de commande produite par la tension grille-émetteur auxiliaire.

9. Dispositif de protection suivant la revendication 8,
**caractérisé en ce que**
la borne (S52) de commande de l'élément (52) de coupure commandé en tension est soumise à la tension grille-émetteur auxiliaire par l'intermédiaire d'un relais (51) temporisateur.

10. Agencement comprenant un interrupteur (10 ) à semi-conducteur commandé en tension, un dispositif (30) de protection suivant l'une des revendications précédentes et un circuit (20) de commande pour commander l'interrupteur (10) à semi-conducteur, le circuit de commande étant connecté à la borne (G10) de grille et à la borne (H10) d'émetteur auxiliaire et commandant l'interrupteur (10) à semi-conducteur commandé en tension par l'intermédiaire de la tension grille-émetteur auxiliaire.

11. Procédé de protection d'un interrupteur (10) à semi-conducteur commandé en tension, qui est équipé d'une borne (G10) de grille, d'une borne (L10) d'émetteur de puissance, d'une borne (H10) d'émetteur auxiliaire et d'une borne (K10) de collecteur, dans lequel
- on limite la tension entre la borne (G10) de grille et la borne (L10) d'émetteur de puissance par un dispositif (40) de limitation de la tension, si l'interrupteur (10) à semi-conducteur commandé en tension est fermé, **caractérisé en ce que**
- on désactive le dispositif (40) de limitation de la tension par un dispositif (50) de désactivation pendant la fermeture de l'interrupteur (10) à semi-conducteur et on diminue ainsi des pertes de fermeture à la fermeture de l'interrupteur (10) à semi-conducteur.

12. Procédé suivant la revendication 11,
**caractérisé en ce que**
- on contrôle un saut de la tension entre la borne de grille et la borne d'émetteur auxiliaire et
- on désactive le dispositif (40) de limitation de la tension, s'il se produit un tel saut de tension.
